# EUROPEAN PATENT APPLICATION

(11) **EP 4 730 636 A1**
(43) Date of publication of application: **22.04.2026**
(21) Application number: 24825831.1
(22) Date of filing: 14.06.2024
(51) Int. Cl.: H02M 7/48

(54) **REFRIGERANT ABNORMALITY DETERMINATION DEVICE, POWER CONVERSION DEVICE, AND REFRIGERANT ABNORMALITY DETERMINATION METHOD**

(30) Priority: 19.06.2023 JP 2023099724
(71) Applicant: Meidensha Corporation, Tokyo 141-6029 (JP)
(72) Inventor: KURODA, Gun, Tokyo 141-6029 (JP)
(74) Representative: Müller-Boré & Partner Patentanwälte PartG mbB
(86) International application number: PCT/JP2024/021663
(87) International publication number: WO 2024/262428

(57) **Abstract**

In a refrigerant abnormality determination device 1 for a power conversion device that cools a switching element with a refrigerant and is provided with a thermistor 6 for temperature protection, a pre-filter thermistor estimation temperature calculation unit 2 calculates a pre-filter thermistor estimation temperature based on a thermistor temperature table 21 using a current command value or a current detection value of the power conversion device as parameters. The pre-filter thermistor estimation temperature is input to a filter 3. An adder 5 calculates a thermistor estimation temperature by adding a refrigerant temperature value from a refrigerant temperature sensor 4 to a value output from the filter 3. An abnormality determination unit 8 determines that the refrigerant is abnormal when a continuous period during which a difference between a slope of a thermistor detection temperature from the thermistor 6 and a slope of the thermistor estimation temperature from the adder 5 is equal to or above a threshold value is equal to or longer than a determination time.

## Description

### TECHNICAL FIELD

The present invention relates to temperature protection technology for IGBTs (Insulated Gate Bipolar Transistors) in power conversion devices.

### BACKGROUND TECHNOLOGY

Power conversion devices (such as a motor-drive inverter) equipped with switching elements may include an IGBT module mounting switching elements that is equipped with a thermistor. Thermal protection for the switching element chips is performed based on the temperature detected by the thermistor.

In addition, as a cooling technique for the switching elements, cooling water is circulated as a refrigerant through a water-cooled case in contact with the IGBT module such that the module is cooled via heat exchange. The cooling effect of the switching elements increases as the flow rate of the cooling water increases.

When using a thermistor type as a temperature detection means for an IGBT chip in a water-cooled inverter, the chip temperature can only be measured indirectly. Therefore it is necessary to either limit the output according to the operating conditions or estimate the chip temperature to maintain the rated temperature and protect the chip from thermal damage. That is, there is a temperature difference between the temperature at the measuring portion of a thermistor and the chip temperature, based on the thermal resistance therebetween.

The water-cooled case of the water-cooled inverter typically receives cooling water at or above a reference flow rate. Therefore the protection value based on the thermistor temperature is set assuming a cooling water flow rate at or above the reference value.

As described above, the protection based on the thermistor temperature is not performed by directly measuring the chip temperature like the temperature sensor diode type. Consequently, temperature rises caused by the abnormality of cooling water (such as cooling hose detachment) cannot be detected, potentially damaging the switching elements. In Particular, it may fail to detect operational abnormalities in components such as a cooling water pump in time, risking IGBT damage. Furthermore, since the thermistor has a thermal time constant larger than that of the IGBT chip, temperature protection for the chip in a transient state due to a reduction in coolant flow cannot be performed.

Equipping the device with a cooling water flow sensor enables detection of cooling abnormalities, but results in increased equipment cost and size.

To solve these problems, a technique has been proposed (patent document 1) that performs temperature protection for switching elements and detects the abnormalities of cooling system based on the slope of temperature change in the inverter.

### PRIOR ART DOCUMENT(S)

### PATENT DOCUMENT(S)

Patent Document 1: Japanese Patent Application Publication No. 2015-136217

### SUMMARY OF THE INVENTION

A technique for detecting the above-mentioned abnormality based on the slope of temperature change in an inverter, as described in the patent document 1, assumes that the power loss of the switching elements (namely, inverter load) remains constant during temperature changes. Under conditions in which the inverter load fluctuates, detecting cooling system abnormalities becomes difficult.

In view of the above circumstances, an object of the present invention is to reliably detect refrigerant abnormalities to thermally protect the switching elements even under conditions in which the inverter load fluctuates.

Therefore, the present invention, in one aspect thereof, is a refrigerant abnormality determination device for a power conversion device that cools a switching element with a refrigerant and is provided with a thermistor for temperature protection for the switching element, including: a pre-filter thermistor estimation temperature calculation unit configured to calculate a pre-filter thermistor estimation temperature based on a thermistor temperature table using a current command value or a current detection value of the power conversion device as parameters; a filter to which the pre-filter thermistor estimation temperature is input; an adder configured to calculate a thermistor estimation temperature by adding a refrigerant temperature value from a refrigerant temperature sensor to a value output from the filter; and an abnormality determination unit configured to determine that the refrigerant is abnormal when a continuous period during which a difference between a slope of a thermistor detection temperature from the thermistor and a slope of the thermistor estimation temperature from the adder is equal to or above a threshold value is equal to or longer than a determination time.

In the refrigerant abnormality determination device in one aspect of the present invention, the thermistor is provided in a module of the switching element.

In the refrigerant abnormality determination device in one aspect of the present invention, a carrier frequency of a gate on/off command for the switching element, and a motor rotation speed command value or a motor rotation speed detection value are used as parameters for the thermistor temperature table.

In the refrigerant abnormality determination device in one aspect of the present invention, the thermistor temperature table shows a relationship between the thermistor temperature and the current command value or the current detection value, the carrier frequency, the motor rotation speed command value or the motor rotation speed detection value, and a reference flow rate of the refrigerant, and this relationship is obtained based on an actually measured value of a temperature of the thermistor when the power conversion device is operated under the predetermined current command value or current detection value, carrier frequency of the gate on/off command for the switching element, motor rotation speed command value or motor rotation speed detection value, and reference flow rate of the refrigerant.

The present invention, in one aspect thereof, is the power conversion device comprising the refrigerant abnormality determination device.

The present invention, in one aspect thereof, is a refrigerant abnormality determination method performed by a refrigerant abnormality determination device for a power conversion device that cools a switching element with a refrigerant and is provided with a thermistor for temperature protection, including: calculating a pre-filter thermistor estimation temperature based on a thermistor temperature table using a current command value or a current detection value as parameters; inputting the pre-filter thermistor estimation temperature to a filter; calculating a thermistor estimation temperature by adding a refrigerant temperature value from a refrigerant temperature sensor to a value output from the filter; and determining that the refrigerant is abnormal when a continuous period during which a difference between a slope of a thermistor detection temperature from the thermistor and a slope of the calculated thermistor estimation temperature is equal to or above a threshold value is equal to or longer than a determination time.

According to the present invention, it is possible to determine refrigerant abnormalities and provide thermal protection for the switching elements even under conditions in which the inverter load fluctuates.

### BRIEF DESCRIPTION OF THE DRAWINGS

FIG. 1 is a block diagram of a refrigerant abnormality determination device according to one aspect of the present invention.
FIG. 2 is a detected and estimated values of thermistor temperature over time.
FIG. 3 is the slopes of the detected and estimated values of the thermistor temperature in FIG. 2.
FIG. 4 is an explanatory diagram of refrigerant abnormality determination based on the slope values in FIG. 3.

### MODE FOR IMPLEMENTING THE INVENTION

In the following, an embodiment of the present invention will be explained while referring to the drawings.

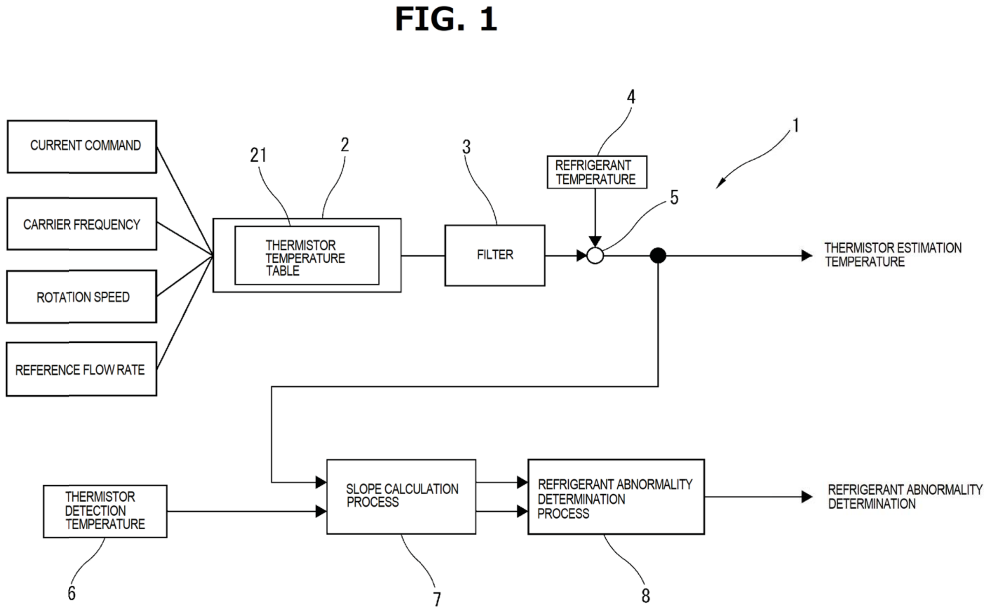

A refrigerant abnormality determination device 1 that is shown in FIG. 1 and is one aspect of the present invention determines abnormalities in the refrigerant used to thermally protect a switching element (IGBT) of a power conversion device employing a thermistor-based temperature monitoring.

The refrigerant may be conventional cooling water, cooling oil, or the like used in the power conversion device. An abnormality in the refrigerant includes, for example, leakage of the refrigerant due to damage or detachment of a refrigerant supply line. The module of the switching element is joined to a refrigerant case (not shown).

The refrigerant abnormality determination device 1 is provided with a pre-filter thermistor estimation temperature calculation unit 2, a filter 3, a refrigerant temperature sensor 4, an adder 5, a thermistor 6, a slope calculation unit 7, and an abnormality determination unit 8.

The pre-filter thermistor estimation temperature calculation unit 2 calculates the pre-filter thermistor estimation temperature based on a thermistor temperature table 21 using the current command value or current detection value of the power conversion device as parameters.

The thermistor temperature table 21 shows the relationship between the thermistor temperature and the current command value or current detection value, the carrier frequency of a gate on/off command for the switching element, a motor rotation speed command value or motor rotation speed detection value, and the reference flow rate of the refrigerant. This relationship is obtained based on the actually measured value of the thermistor temperature when the power conversion device is operated under predetermined current command value or current detection value, carrier frequency of the gate on/off command for the switching element, motor rotation speed command value or motor rotation speed detection value, and reference flow rate of the refrigerant.

The filter 3 has a function for outputting with a delay corresponding to the thermistor thermal time constant relative to the time variation of the input value (representative example: RC filter), and the pre-filter thermistor estimation temperature from the pre-filter thermistor estimation temperature calculation unit 2 is input thereto. The thermistor thermal time constant is determined based on the thermal time constant of the refrigerant case and the thermal time constant of the switching element.

The refrigerant temperature sensor 4 is provided at the input portion of the refrigerant case (not shown) that stores the refrigerant and detects the refrigerant temperature.

The adder 5 calculates the thermistor estimation temperature by adding the refrigerant temperature value detected by the refrigerant temperature sensor 4 to the value output from the filter 3.

The thermistor 6 is provided in the module of the switching element for thermal protection of the switching element and outputs the detected temperature as the thermistor detection temperature.

The slope calculation unit 7 calculates the slope of the thermistor estimation temperature received from the addition unit 5 and the thermistor detection temperature received from the thermistor 6.

The abnormality determination unit 8 determines that the refrigerant is abnormal when a continuous period during which the difference between the slope of the thermistor detection temperature and the slope of the thermistor estimation temperature is equal to or above a threshold value is equal to or longer than a determination time.

Referring to FIGS. 1-4, an example of the operation of the refrigerant abnormality determination device 1 is described.

First, through preliminary test, the thermistor temperature (at saturation) is measured when the power conversion device is operated with predetermined inverter (motor) current command value related to the loss generated by the switching element, carrier frequency of the gate on/off command for the switching element, motor rotation speed, and reference flow rate of cooling water (refrigerant). The reference flow rate of the cooling water is set to the minimum flow rate at which actual load operation can be performed. Then, based on the actually measured thermistor temperature value, the thermistor temperature table 21 is created. This thermistor temperature table 21 shows the relationship between the thermistor temperature and the current command value, carrier frequency, motor rotation speed detection value (or motor rotation speed command value), and reference flow rate of cooling water. This thermistor temperature table 21 is stored in the pre-filter thermistor estimation temperature calculation unit 2. In addition, when the carrier frequency is constant at all times or when the inverter is loaded with a load other than the motor, only the current command value may be used as the parameter. Alternatively, the current detection value may be used as the parameter instead of the current command value.

Next, in actual load operation, the pre-filter thermistor estimation temperature calculation unit 2 calculates the pre-filter thermistor estimation temperature based on the thermistor temperature table 21, using the current command value, the carrier frequency, the motor rotation speed detection value or the motor rotation command value, and the reference flow rate of the cooling water. This pre-filter thermistor estimation temperature is input to the filter 3.

The adder 5 calculates the thermistor estimation temperature by adding the refrigerant temperature value from the refrigerant temperature sensor 4 to the value output from the filter 3. In this way, the pre-filter thermistor estimation temperature calculated by the pre-filter thermistor estimation temperature calculation unit 2 is supplied to the adder 5 via the filter 3, taking into account the thermal time constant of the refrigerant case. Consequently, the accuracy of the thermistor estimation temperature at the time of sudden changes in generated loss of the switching element is improved.

Next, the slope calculation unit 7 calculates each of the slope of the thermistor estimation temperature supplied from the adder 5 and the slope of the thermistor detection temperature supplied from the thermistor 6.

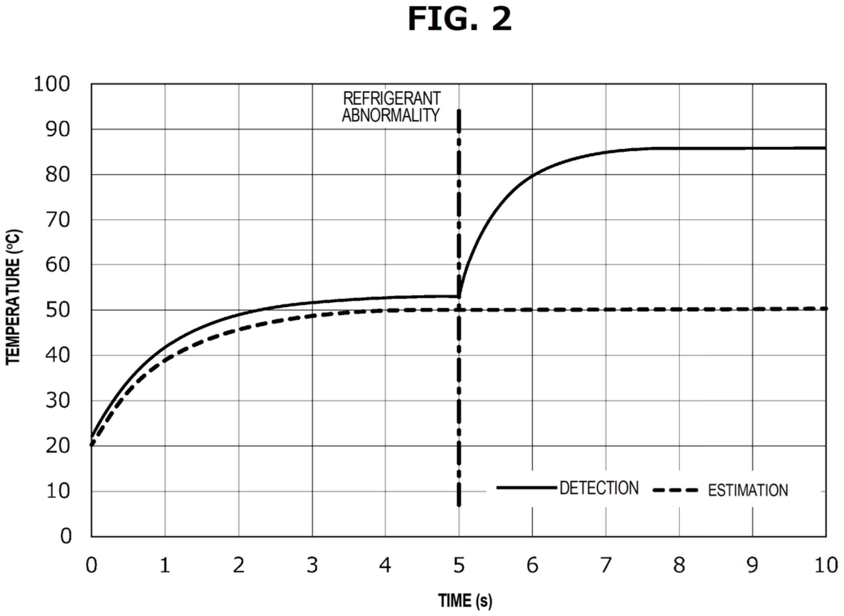

Then, the abnormality determination unit 8 performs, for example, the determination process for the refrigerant abnormality shown in FIGS. 2-4.

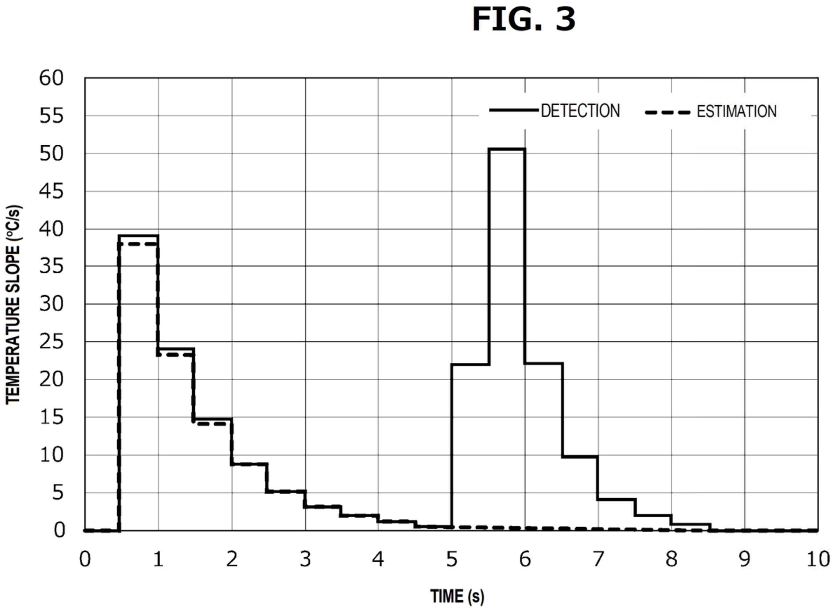

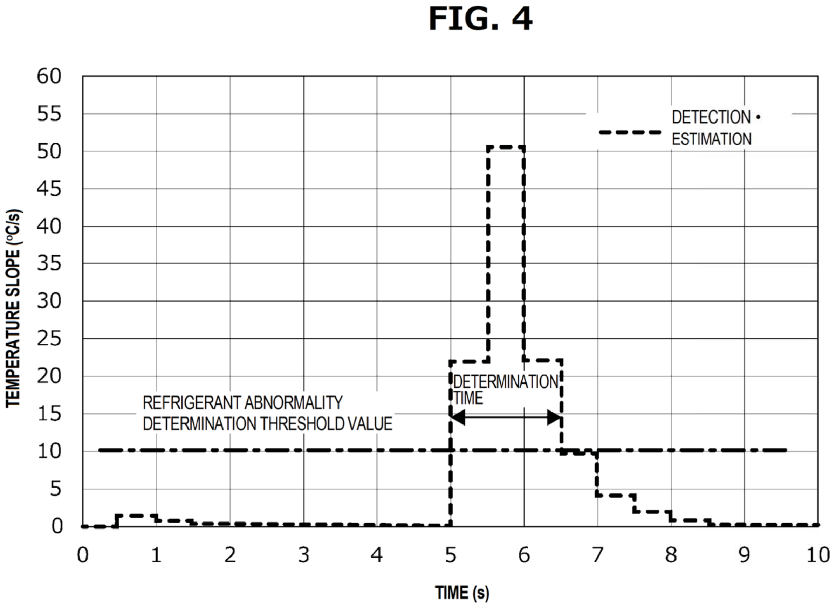

The thermistor detection temperature and the thermistor estimation temperature during normal operation transition from 0 to 5s as shown in FIG. 2. The estimation temperature is higher than the detection temperature because it is estimated using a worst-case value that accounts for detection variations, and the like. The slopes of the detection temperature and the estimation temperature calculated by the slope calculation unit 7 are as shown in FIG. 3 (processing cycle 500ms). From 0.5s to 4s in FIG. 3, the temperature rise component due to normal inverter operation appears. Here, to remove this temperature rise component due to the normal inverter operation, the difference between the slope of the thermistor detection temperature and the slope of the thermistor estimation temperature (detection temperature slope - estimation temperature slope) is calculated, thereby extracting only the temperature rise component due to the refrigerant abnormality (for example, cooling water leakage), as illustrated in FIG. 4. Then, when the continuous period during which the difference in slopes is equal to or above a threshold value is equal to or longer than predetermined determination time, the refrigerant is determined to be abnormal. The threshold value and determination time are set to values capable of performing the temperature protection of the switching element based on the above-mentioned preliminary test.

When the abnormality is detected, the inverter is stopped by turning off all switching elements, and a fault signal indicating leakage of cooling water is output externally. With this, it is possible to prevent damage to the switching elements due to high temperature.

Therefore, according to the refrigerant abnormality determination device 1 of the present embodiment, even when the inverter load fluctuates, the determination of refrigerant abnormality and the temperature protection of the switching elements can be performed by using the thermistor temperature table 21 and the filter 3. In addition, it becomes possible to determine abnormalities such as leakage of cooling water and protect the switching elements without requiring a flow rate sensor for cooling water, thereby reducing cost and size of the inverter device.

In the above embodiment, the characteristic of a thermistor temperature rapid rise at the time of cooling water leakage is utilized. However, the present invention can also be applied to configurations in which the thermistor is located at a position other than the IGBT module (for example, on the surface of the refrigerant case). Furthermore, it can be applied to refrigerants other than cooling water (for example, cooling oil).

### EXPLANATION OF SYMBOLS

1 Refrigerant abnormality determination device
2 Pre-filter thermistor estimation temperature calculation unit, 21...Thermistor temperature table
3 Filter
4 Refrigerant temperature sensor
5 Adder
6 Thermistor
7 Slope calculation unit
8 Abnormality determination unit

## Claims

1. A refrigerant abnormality determination device for a power conversion device that cools a switching element with a refrigerant and is provided with a thermistor for temperature protection for the switching element, comprising:
a pre-filter thermistor estimation temperature calculation unit configured to calculate a pre-filter thermistor estimation temperature based on a thermistor temperature table using a current command value or a current detection value of the power conversion device as parameters;
a filter to which the pre-filter thermistor estimation temperature is input;
an adder configured to calculate a thermistor estimation temperature by adding a refrigerant temperature value from a refrigerant temperature sensor to a value output from the filter; and
an abnormality determination unit configured to determine that the refrigerant is abnormal when a continuous period during which a difference between a slope of a thermistor detection temperature from the thermistor and a slope of the thermistor estimation temperature from the adder is equal to or above a threshold value is equal to or longer than a determination time.

2. The refrigerant abnormality determination device according to claim 1,
wherein the thermistor is provided in a module of the switching element.

3. The refrigerant abnormality determination device according to claim 1,
wherein a carrier frequency of a gate on/off command for the switching element, and a motor rotation speed command value or a motor rotation speed detection value are used as parameters for the thermistor temperature table.

4. The refrigerant abnormality determination device according to claim 3,
wherein the thermistor temperature table shows a relationship between the thermistor temperature and the current command value or the current detection value, the carrier frequency, the motor rotation speed command value or the motor rotation speed detection value, and a reference flow rate of the refrigerant, and this relationship is obtained based on an actually measured value of a temperature of the thermistor when the power conversion device is operated under the predetermined current command value or current detection value, carrier frequency of the gate on/off command for the switching element, motor rotation speed command value or motor rotation speed detection value, and reference flow rate of the refrigerant.

5. The power conversion device comprising the refrigerant abnormality determination device according to claim 1.

6. A refrigerant abnormality determination method performed by a refrigerant abnormality determination device for a power conversion device that cools a switching element with a refrigerant and is provided with a thermistor for temperature protection, comprising:
calculating a pre-filter thermistor estimation temperature based on a thermistor temperature table using a current command value or a current detection value as parameters;
inputting the pre-filter thermistor estimation temperature to a filter;
calculating a thermistor estimation temperature by adding a refrigerant temperature value from a refrigerant temperature sensor to a value output from the filter; and
determining that the refrigerant is abnormal when a continuous period during which a difference between a slope of a thermistor detection temperature from the thermistor and a slope of the calculated thermistor estimation temperature is equal to or above a threshold value is equal to or longer than a determination time.
